# EUROPEAN PATENT APPLICATION

(11) **EP 4 557 320 A1**
(43) Date of publication of application: **21.05.2025**
(21) Application number: 23210187.3
(22) Date of filing: 15.11.2023
(51) Int. Cl.: H01C 1/14, G01R 15/04, H01C 3/10, H01C 3/20, H01C 7/22, H05K 1/16, H01C 3/12, H01C 1/148

(54) **RESISTOR STRUCTURE AND A VOLTAGE DIVIDER ARRANGEMENT**

(71) Applicant: ABB SCHWEIZ AG, 5400 Baden (CH)
(72) Inventor: HOZOI, Adrian, 68219 Mannheim (DE); SOMMER, Felix, 64285 Darmstadt (DE); MIGUNOV, Vadim, 68526 Ladenburg (DE); VELESIK, Peter, 602 00 Brno (CZ)
(74) Representative: Maiwald GmbH

(57) **Abstract**

The invention relates to a resistor structure comprising at least an electrically insulating ceramic substrate, at least one electrically conductive terminal directly or indirectly provided on the substrate, at least one resistive path directly or indirectly and at least partially provided on the substrate and directly or indirectly joined to the terminal, characterized in that an insulator film is at least partially applied directly on the substrate and, when viewed in the thickness direction facing away from the substrate, at least in part provided between the substrate and the resistive path and/or the at least in part between the substrate and the terminal.

## Description

### Field of the invention

The present invention concerns a resistor structure and a voltage divider arrangement as well as electric devices comprising such resistor structure and/or voltage divider arrangement.

### Background

Resistor structures and voltage divider arrangements are configured for high voltage applications, for example between 500 V and 1000 kV. Resistors which are employed at high voltages feature a high resistance to limit power dissipation, e.g. larger than 100 kΩ.

Resistor structures may comprise an electrically insulating substrate, at least one electrically conductive terminal applied on the substrate, and at least one resistive path applied on the substrate and joined to the terminal.

A voltage divider arrangement may, in its simplest embodiment, comprise two resistor structures electrically connected in series for transforming a high voltage, so-called primary voltage, to a lower voltage, so-called secondary voltage. The secondary voltage is significantly smaller than the primary voltage, e.g. by a voltage divider ratio between 10 to 100 000. In more complex embodiments of a voltage divider, one or both of the serial resistor structures may be replaced by resistive networks. The resistors or corresponding resistor networks may be referred to as high and low ohmic resistors, respectively.

These devices may be integrated in electrical devices, in which in particular severe operating conditions such as strong voltage overloads, power overloads, temperature variations, humidity variations, mechanical stresses and shocks may occur. Example electric devices are electronic instrument transformers (sensors), such as the KEVCD and KEVA sensor types of ABB, which are commonly employed in electrical power systems with a rated primary voltage between 7.2 kV and 48 kV.

US 9, 299, 484 B2, the contents of which is incorporated, discloses a resistive structure as well as a resistive voltage divider arrangement.

High voltage applications typically require particular engineering efforts, to ensure both functionality and safety. The reason is that such resistor structures are exposed to a high electric field intensity, typically imposing excessive electric stresses. This may result in dielectric failures, like partial discharge or electrical breakdown.

Therefore, it is desired to improve resistor structures and voltage divider arrangements as to manufacture, reliability and safety.

### Summary

The invention concerns a resistor structure comprising at least an electrically insulating ceramic substrate, at least one, preferably two electrically conductive terminals directly or indirectly provided on the substrate, at least one resistive path (optionally in parts) directly or indirectly provided on the substrate and directly or indirectly joined to the terminal. An insulator film is at least partially applied directly on the substrate and, when viewed in the thickness direction facing away from the substrate, at least in part provided between the substrate and the resistive path and/or at least in part between the substrate and the terminal.

According to the present invention, an insulator/insulating film is provided directly on top of the insulating substrate. The insulating film may be seen as an underlying or base insulator film. The insulator film may represent a barrier between the electrically insulating substrate made of ceramics and layers which are provided on the insulating substrate, such as a resistive path and/or a terminal. The insulating film of the invention is seen as providing a (overall or selective) separation between the insulating substrate and upper layers such as the resistive path and the terminal.

Typically, an insulating substrate is made of ceramics, which are polycrystalline materials formed by multiple crystal grains joined together during the production process, more specifically during sintering. This may be identifiable by methods like microscopy (for example optical, electron, or scanning probe) or micro computed tomography. Boundaries between crystal grains may cause imperfections like tiny voids, which may degrade the electrical properties of the substrate and, hence, lead to partial discharges and even complete failure. This may affect the safety or reliability of the resistor structure, or lead to a drift of the resistance value of the resistive structure and, hence, degrade the accuracy of the resistor structure.

By way of the insulating film, e.g. diffusion of metal atoms from the terminal into the insulating substrate may be prevented. At the same time or alternatively, the insulating film may be seen as sealing porous imperfections at the surface of the insulating substrate. This may support the reliability of the resistive structure and the stability of the resistance value of the resistive structure and, hence, improve the accuracy of the resistor structure.

Accordingly, the accuracy and the voltage withstand of the resistor structure and of the corresponding voltage divider arrangement may be enhanced.

Additional layers between the substrate and the film are not excluded. Likewise, additional layers may be provided between the film and the resistive path or the terminal.

Resistive materials commonly employed in thick film technology are based on formulations mainly comprising glass, particles of conductive oxide ceramic such as ruthenium oxide, and possibly other additives such as metal particles. Thick film resistive materials or films have a resistivity (sheet resistance) usually comprised between 50 mΩ/square and 1 GΩ/square.

In the context of the invention, a resistive trace of the resistive path is made of a resistive material with resistivity preferably between 50 Ω/square and 100 MΩ/square, or preferably between 500 Ω/square and 10 MΩ/square. Non-exhaustive examples of possible resistive materials are the R8700 Series from Heraeus or the 2000 Series from DuPont.

Electrically conductive materials commonly employed in thick film technology are based on formulations comprising a major amount of metal particles like Ag, Pd, Au, Pt and possibly other additives. Conductive materials comprising a significant content of Ag are often employed because of its very high conductivity, relatively low cost, and excellent compatibility to soldering alloys being employed in the electronic industry. Thick film conductor materials or films have a resistivity usually comprised between 1 mΩ/square and 1 Ω/square. Non-exhaustive examples of possible conductive materials are the C2210 from Heraeus or the 7484 from DuPont.

An insulator material is seen as having a volume resistivity larger than 10⁷ Ω·cm.

The resistive path comprises one or more resistive traces. If more resistive traces are provided, the resistive traces may be connected directly or indirectly and at least partly in series or in parallel.

Optionally, the resistive path comprises resistive traces which are electrically connected in series by transition elements to form the resistive path. Resistive traces may, at least partially, run parallel to each other.

Optionally, the insulating film is selectively applied on the substrate and/or parts of the substrate along which the resistive path runs, are free of the insulating film. In this case, the provision of the insulating film can be tailored to parts which are sensitive. This saves material.

Optionally, the resistor structure comprises at least one transition element for connecting resistive traces forming the resistive path. Further optionally, the insulating film is at least in part, when viewed in the direction facing away from the substrate, between the substrate and the transition element. By providing an insulating film also below the transition elements, undesired effects can be avoided in relation to the transition elements.

Optionally, a thickness of the insulating film is between 2 and 40 µm. This thickness may be sufficient to provide the desired barrier, while trying to avoid using excess material.

Optionally, the insulating film comprises a number of insulating film parts, further optionally distanced from each other along the substrate. Individual parts of the film or connected parts of the film may be provided, so as to locate the insulating film in regions where more necessary than in other regions. If the parts are connected to each other, this may be beneficial as to alignment during manufacture.

Optionally, the insulating film comprises a number of layers, further optionally provided on top of each other and/or distanced from each other along the substrate. If the insulating film comprises a number of film layers which are provided on top of each other, the film thickness can be increased by simple means during manufacture, namely by depositing an insulating film in subsequent steps. If a film having parts with different thicknesses is desired, parts of the film may selectively be deposited, in particular stacks with selected height/thickness may be deposited.

Optionally, the insulating film has different thicknesses, further optionally thicknesses between 2 and 80 µm. If the insulating film has different thicknesses so that no uniform film thickness is provided, thicknesses may have a range between 2 and 80 µm, which may be seen as balancing reduction of material and effective protection. In some embodiments, the thickness of a first insulating film part may be larger than the thickness of a second insulating film part, preferably by at least 50% or at least 5 µm. Further preferably, the thickness of the second insulating film part may be between 2 and 40 µm.

Optionally, the dielectric strength of the insulator film is larger than the dielectric strength of the substrate and/or the porosity of the insulator film is smaller than the porosity of the substrate. Accordingly, this may support the impact of the insulator film.

Optionally, the insulating film comprises at least 10%, at least 50% of glass. In this case, the porosity of the insulating film is seen as appropriately reduced compared to the porosity of the ceramic substrate. The insulating film and the ceramic substrate may be made of different materials.

Optionally, the insulating film at least partially runs perpendicular to the resistive path. Alternatively or additionally, the insulating film at least partially runs parallel to a part of the terminal or the resistive path. Such extension of the insulating film allows for a suitable geometry and dimension of the insulating film while providing an appropriate barrier by way of the insulating film.

Optionally, the insulating film at least partially extends beyond/projects from a part of the resistive path and/or of the terminal, in a direction perpendicular to the thickness direction, i.e. on the surface of the substrate. This ensures appropriate protection by way of the insulating film and, at the same time, allows to compensate potential misalignment of the resistive path and/or the terminal relative to the insulating film during manufacture.

Optionally the insulating film is positioned underneath at least a part of the resistive path, at which the resistive path ends or changes its direction, such as at a turnaround. Such sections may be seen as sensitive, so that it is efficient to provide the film at least in these sections.

Optionally, the insulating film is provided underneath at least a part of the resistive path comprising a discontinuity of the resistive path. This helps to increase the dielectric strength of the substrate near the discontinuities of the resistive path. In general, a discontinuity of the resistive path may be a portion of the resistive path like a bend, for example of more than 15° or 30°, or a portion of the resistive path where there is a change of the width of the path, for example of more than 20%, or an end of the resistive path, or an end of a resistive trace of a resistive path.

Optionally, the insulating film is provided underneath a terminal portion facing the resistive path, the resistive path being connected to the terminal.

Optionally, the insulating film is below a transition element connected to a resistive trace of the resistive path and/or below an interconnecting element connecting at least two resistive traces of the resistive path and the portion of the terminal and/or below an interconnecting path connecting at least an end of a first resistive path and an end of a second resistive path and the portion of a terminal, wherein the resistive path comprises at least the first and second resistive paths. Providing an insulating film below a transition element, an interconnecting element and an interconnecting path provides protection for sensitive regions.

Resistor structures of the invention may be manufactured using thick film technology, e.g. screen printing or stencil printing or direct printing through a nozzle. Films of conductive material and of resistive material are sequentially deposited on an insulating substrate. Typically, a single layer of a single material is deposited, followed by a subsequent step such as drying or firing. For example, conductive film or a resistive film are fired at a very high temperature, between 600°C and 950°C.

The insulating substrate may be made of ceramic material, such as aluminum oxide or aluminum nitride. The insulating substrate may be in the form of a flat, planar sheet or, alternatively, in the form of a cylinder.

In addition to the first electrically conductive terminal, at least a second electrically conductive terminal may be typically provided in a resistive structure, wherein the resistive path connects to the first and second terminals. In a voltage divider, the high and low-ohmic resistors may share a terminal, so that a voltage divider arrangement may comprise at least first, second and third terminals.

The resistive path may comprise, in addition to the at least first resistive path, a second resistive path, wherein the paths are connected in series. A resistive path (or the resistive paths) may at least partially be in the form of a helix. Hence, the resistive path may at least partially run helically along a cylindrical substrate.

A coating made of an electrically insulating material may be provided. In some embodiments, the coating may be the outermost entity or layer. The coating may cover the entire remaining resistive structure or partially. The coating may cover at least part of the resistive path and possibly part(s) of the terminal(s). A part of each terminal is preferably not covered by the coating in order to provide electrical connection(s) to the resistive structure. The coating may be a film made of a material based on glass or of a substantially the same material like of the insulator film. This may help the coating film to better bind with the insulator film and to seal even better the resistive path and parts of the resistor structure and to better withstand electric stresses. A thickness of the coating film may be between 3 to 100 µm, or between 3 and 30 µm.

The insulator film may be provided, at all or with higher thickness, in specific regions of the structure/path and may occupy less than 40% of the resistive path. The main part of the resistive path, more than 60%, may be on the substrate or on a "thinner" film.

The coating film may correspond to the insulator film in various embodiments.

Optionally, the coating film comprises at least a first coating film part being provided in a portion of the resistor structure being substantially the same as the first insulator film part and having substantially a same shape and a same surface area as the first insulator film part.

Optionally, the coating film comprises at least a second coating film part being provided in a portion of the resistor structure being substantially the same as the second insulator film part and having substantially a same shape and a same surface area as the second insulator film part.

Optionally, a thickness of the first coating film part, being between 5 to 100 µm, is larger than a thickness of the second coating film part, being between 3 to 30 µm, by at least 50% or at least 5 µm.

Optionally, a second coating, e.g. made of a polymer, may be applied on a first coating. The second coating may be thicker than the first coating.

A shunt may be provided. A shunt section is configured to shunt a distinct portion of a resistive trace to proportionally reduce its effective resistive length. This may mean that the length which is electrically effective (and, thus, determines the electrical resistance of the trace) is shorter than the actual length of the trace. A transition element may act as shunt section. A shunt section has a lower resistivity than the resistive trace to which the shunt section (e.g. transition element) is connected to.

Optionally, the insulator film comprises a first insulator film part eing provided on the substrate and the resistive path comprises one or more portions being applied on the first insulator film part, where the total length of the portions of the resistive path being applied on the first insulator film part is less than 40% the length of the resistive path and where the remaining resistive .

Optionally, the resistive path comprises one or more portions being applied directly on the substrate, where the total length of the portions of the resistive path being applied directly on the substrate is more than 60%.

Optionally, the insulator film comprises a second insulator film part being provided on the substrate and the resistive path comprises one or more portions being applied on the second insulator film part, where the total length of the portions of the resistive path being applied on the second insulator film part is at least 30% or preferably at least 60% the length of the resistive path, and where a thickness of the first insulator film part is larger than a thickness of the second insulator film by at least 50% or at least 5 µm.

Optionally, the thickness of the first insulator film part is between 5 and 80 µm, and a thickness of the second insulator film part is between 2 and 40 µm.

Optionally, the resistor structure comprises resistive traces being mainly identical and being preferably arranged periodically with mainly a same pitch. The resistive traces may be made of a same resistive material, and may have mainly a same thickness, width, slope, and (actual) length. This helps for efficient and reproducible manufacturing of the resistive traces and of the resistive path.
A voltage divider arrangement of the invention may comprise a high ohmic resistor and a low ohmic resistor electrically connected in series, where the voltage divider arrangement comprises at least one resistor structure of the invention. The high ohmic resistor is made of one or more resistive traces and the low ohmic resistor is made of one or more resistive traces, and the high ohmic and the low ohmic resistors differ as to their resistance.

Optionally, the voltage divider arrangement is provided on the same substrate and comprises resistive traces being substantially identical. This may provide an arrangement which is more effective to manufacture and more stable.

An electrical device of the invention comprises a resistor structure or a voltage divider arrangement of the invention.

### Brief description of the drawings

Figure 1 shows a resistor structure of the invention in a plan view.
Figure 2 shows a resistor structure in a voltage divider arrangement of the invention in a plan view.
Figure 3 schematically shows a sectional view of a resistor structure of the invention.
Figure 4 shows resistor structures in a cylindrical voltage divider arrangement of the invention in a perspective view, wherein figures 4(a) and 4(b) show views from different angles.
Figure 5 shows a resistor structure in a voltage divider arrangement of the invention in a plan view.

### Detailed description of embodiments

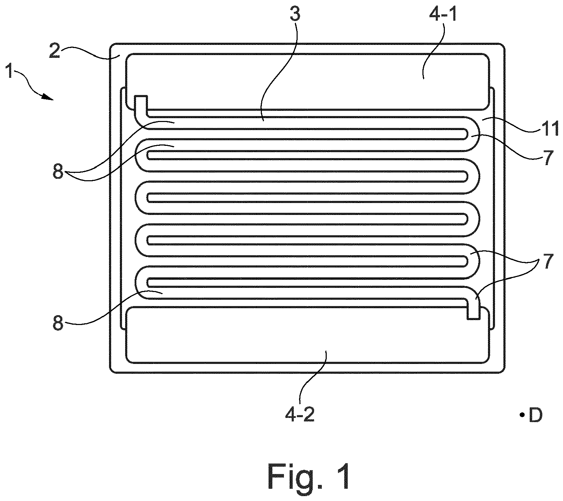

Figure 1 shows a resistor structure 1 comprising at least an electrically insulating substrate 2 made of ceramics. At least one electrically conductive terminal 4 in parts directly and in parts indirectly provided on the substrate 2. A resistive path 3 is indirectly applied to the substrate 2 and connects to the terminal 4. The terminal 4 can be a first terminal 4-1 or a second terminal 4-2 between which the resistive path 3 extends. The resistor structure 1 further comprises an insulator film 11 of electrically insulating material. The film 11 is, in the embodiment of figure 1, directly applied on the substrate. However, the insulator film 11 does not cover the entire substrate 2. The insulator film 11 in the embodiment of figure 1 is a continuous film and is rectangular. Specifically, underneath the entire resistive path 3, the insulating film 11 is provided. The resistive path 3 is, in the embodiment of figure 1, a meander. Between parts of the meander, gaps 6 are present.

A thickness direction D can be defined in the direction facing away from the substrate 2. The film 11 is provided between the substrate 2 and the resistive path 3, and between the substrate 2 and the terminal 4. While the insulator film 11 is, in the embodiment of figure 1, provided in its entirety between the substrate 2 and the resistive path 3, the insulator film 11 is not provided underneath the entire terminal 4. The insulator film 11 provides a barrier, at least along parts of the substrate 2 between the substrate 2 and the upper layers, such as the resistive path 3 and the terminal 4. The effect of the barrier-film 11 may refer to the dielectric strength and the porosity, in that the dielectric strength of the insulator film 11 is larger than the dielectric strength of the substrate 2, and the porosity of the insulator film 11 is smaller than the porosity of the substrate 2.

Figure 1 further shows resistive traces 8 which are connected by way of transition elements 7 with each other so as to from the resistive path 3. A transition element 7 may also be used to connect resistive traces 8 with a terminal 4. Alternatively, the resistive path 3 may consist of one resistive trace 8 being applied as a continuous film of resistive material shaped like a meander, and comprising turnarounds instead of transition elements.

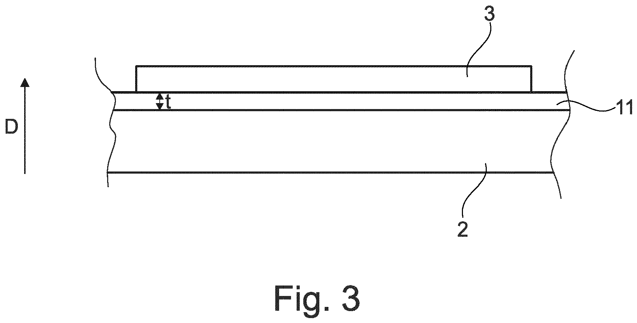

The thickness t of the insulating film 11 is between 2 and 40 µm. The thickness t is indicated in the cross-sectional view of figure 3. Figure 3 shows the substrate 2 as the lowest layer, wherein the insulator film 11 is deposited at least on top of a part of the substrate 2. Figure 3 shows that on top of the insulator film 11, the resistive path 3 is deposited. In figure 3, the film 11 may comprise a number of layers which are provided on top of each other. In this case, the film 11 may have a larger thickness, such as between 5 and 80 µm.

The insulating film 11 and the ceramic substrate 2 are made of different materials. In preferred embodiments, the insulating film 11 comprises at least 10% more preferably at least 50% of glass by weight, e.g. in addition to ceramics.

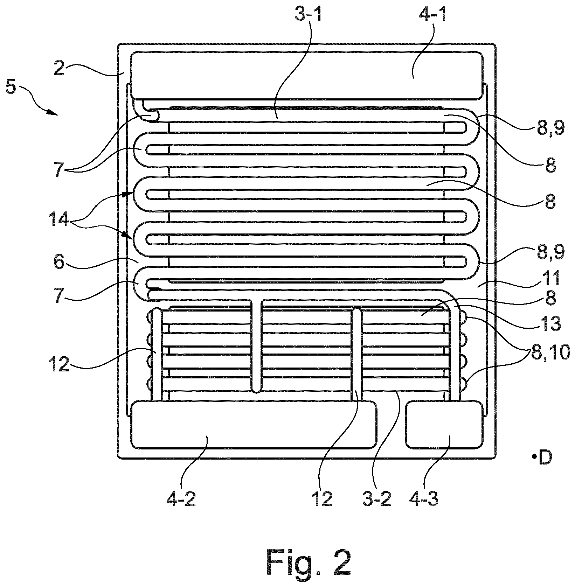

Figure 2 shows a resistive structure 1 in a voltage divider arrangement 5 in which the insulating film 11 is selectively applied. Hence, as the insulating film 11 is not applied on the entire substrate 2, but comprises parts of the films11 which are separated and distanced from each other along the substrate 2, but connected to each other. Some parts of the substrate 2 along which the resistive path 3 runs are free of the insulating film 11. Parts of the insulating film 11 run at least partially perpendicular to the resistive path 3, such as the film parts 11 running from top to bottom on the left and right sides in figure 2. Other parts of the insulating film 11 at least partially run parallel to a part of the resistive path 3 or the terminal 4, such as the part extending from left to right in figure 2. As shown in figure 2, the insulating film 11 is positioned underneath at least a part of the resistive path 3 where the resistive path 3 ends or changes its direction, such as at a turnaround 14. The parts of the film 11 may be rectangular and connected to each other. The plan view of figure 2 also shows that the insulating film 11 is wider than the width of a resistive trace 8 or of the terminal 4. In other words, the insulating film 11 may extend beyond or project from the part of the resistive trace 8 and of the terminal 4 in the direction perpendicular to the thickness direction D, i.e. on the surface of the substrate 2.

The resistive structure 1 may comprise at least one transition element 7 for connecting resistive traces 8. The insulating film 11 is at least in part, when viewed in the direction D facing away from the substrate 2, between the substrate 2 and the transition element 7. A transition element 7 may be connected to a resistive trace 8 and a terminal 4. For example, the transition element 7 joins a portion of the first terminal 4-1 and at the beginning of the resistive trace 8. In the embodiment of figure 2, the insulating film 11 is provided underneath the transition element 7.

In the voltage divider arrangement 5 of figure 2, an interconnecting element 12 connects at least two resistive traces 8 of the resistive path 3 and a portion of a terminal 4-2, wherein the terminal 4 can be a first terminal 4-1 or a second terminal 4-2 or a third terminal 4-3. Also below the interconnecting element 12, an insulating film 11 may be provided. In the embodiment of figure 12, only underneath some of the interconnecting elements 12, the film 11 is provided. The resistor structure 1 may comprise an interconnecting path 13 which connects at least an end of a first resistive path 3-1 and an end of a second resistive path 3-2 and a portion of the terminal 4-3. In this embodiment, the resistor structure comprises a first resistive path 3-1 forming a high-ohmic resistor 9, as well as a second resistive path 3-2 forming a low-ohmic resistor 10. The interconnecting path 13 runs on top of the insulating film 11 in the embodiment of figure 2.

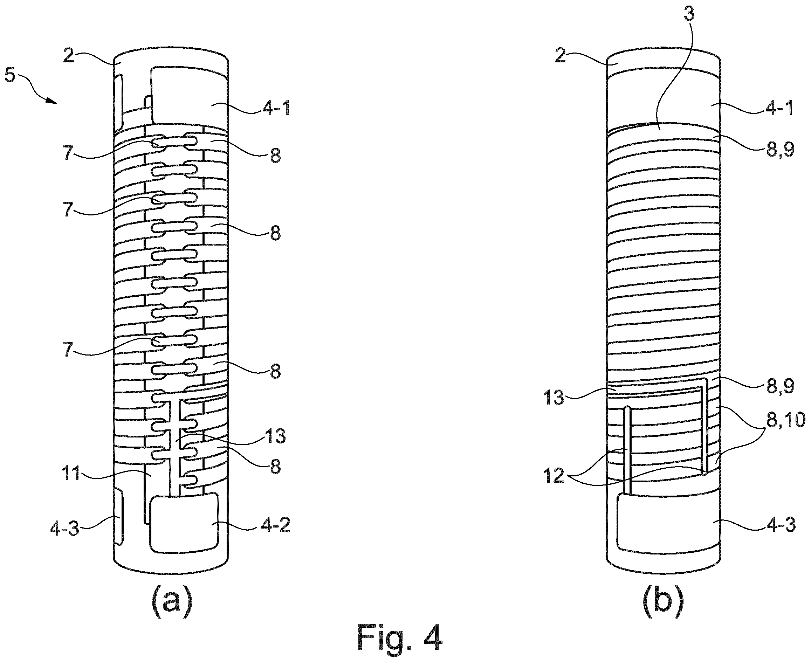

Figure 4(a) and (b) show a voltage divider arrangement 5 having a cylindrical substrate 2 and a resistive path 3 being at least partly shaped like an helix. The voltage divider arrangement includes a resistor structure comprising a first resistive path 3-1 forming a high-ohmic resistor 9, as well as a second resistive path 3-2 forming a low-ohmic resistor 10. The insulating film 11 extends underneath transition elements 7. More specifically, the insulating film 11 extends from the first terminal 4-1 to the second terminal 4-2, via the transition elements 7 and at least a part of an interconnecting path 13. As such, the insulating film 11 substantially runs from one end of the cylinder to the other end of the cylinder forming the substrate 2. The interconnecting path 13 can also be placed in other location, closer to the middle of a trace.

Or it can be said that the insulating film 11 extends from the first terminal 4-1 to the second terminal 4-2 across and in-between the ends of the resistive traces 8 of the resistive path 3, including the first resitive path 3-1 of the high-ohmic resistor 9 and the second resitive path 3-2 of the low-ohmic resistor 10.

The insulator film 11 comprises a first insulator film part 11-1 provided on the substrate and the resistive path comprises one or more portions being applied on the first insulator film part 11-1, where the total length of the portions of the resistive path being applied on the first insulator film part 11-1 is less than 40% the length of the resistive path and where the remaining resistive path. The film part 11-1 may be the same as the film 11 in Figures 2 and 4.

The resistive path comprises one or more portions applied directly on the substrate, where the total length of the portions of the resistive path being applied directly on the substrate is more than 60%.

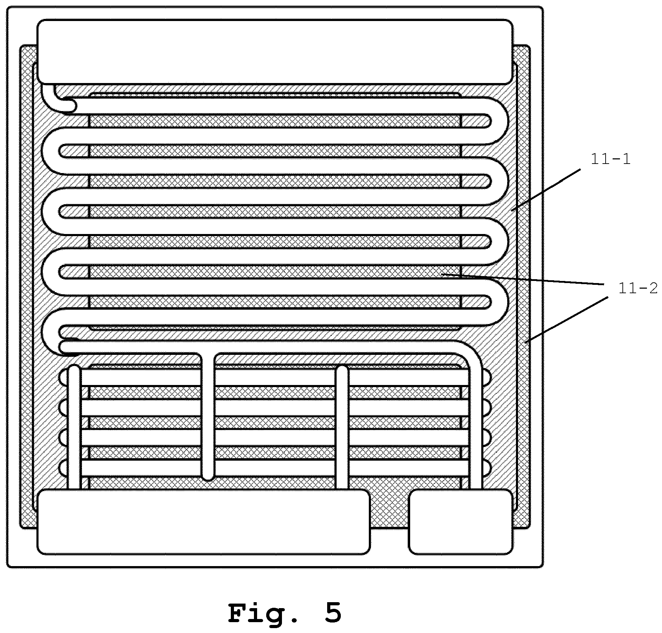

The insulator film 11 comprises a second insulator film part 11-2 provided on the substrate and the resistive path comprises one or more portions being applied on the second insulator film part 11-2, where the total length of the portions of the resistive path applied on the second insulator film part 11-2 is at least 30% or preferably at least 60% the length of the resistive path, and where a thickness of the first insulator film part 11-1 is larger than a thickness of the second insulator film by at least 50% or at least 5 µm. Film part(s) 11-2 is shown in Figure 5, which is based on Figure 2. Basically, the film part(s) 11-2 occupy the portions of the resistor structure / path not occupied by the part(s) 11-1.

The thickness t of the first insulator film part 11-1 is between 5 and 80 µm, and a thickness t of the second insulator film part 11-2 is between 2 and 40 µm.

### Reference signs

1 resistor/resistive structure
2 electrically insulating substrate
3 resistive path
3-1 first resistive path
3-2 second resistive path
4 terminal
4-1 first terminal
4-2 second terminal
4-3 third terminal
5 voltage divider arrangement
6 gap
7 transition element
8 resistive trace
9 high-ohmic resistor
10 low-ohmic resistor
11 insulating film
11-1, 11-2 first, second film parts
12 interconnecting element
13 interconnecting path
14 turnaround of resistive path
D thickness direction
t thickness of insulating film

## Claims

1. Resistor structure (1) comprising at least
an electrically insulating ceramic substrate (2),
at least one electrically conductive terminal (4) directly or indirectly provided on the substrate (2),
at least one resistive path (3) directly or indirectly and at least partially provided on the substrate (2) and directly or indirectly joined to the terminal (4), the resistive path comprising one or more resistive traces (8),
**characterized in that**
an insulator film (11) is at least partially applied directly on the substrate (2) and, when viewed in the thickness direction (D) facing away from the substrate, at least in part provided between the substrate and the resistive path and/or the at least in part between the substrate (2) and the terminal (4).

2. Resistor structure of claim 1, wherein the insulating film (11) is selectively appliedon the substrate (2) and/or parts of the substrate (2) along which the resistive path runs are free of the insulating film (11).

3. Resistor structure of claim 1 or 2, further comprising at least one transition element (7) for connecting resistive traces (8) forming the resistive path (3), wherein optionally the first insulating film part (11-1) is at least in part, when viewed in the direction (D) facing away from the substrate, between the substrate (2) and the transition element (7).

4. Resistor structure of any of the preceding claims, wherein a thickness (t) of the insulating film (11) is between 2 and 80 µm, preferably 2 and 40 µm.

5. Resistor structure of any of the preceding claims, wherein the insulating film (11) comprises a number of insulating film parts, optionally distanced from each other along the substrate (2) or connected to each other.

6. Resistor structure of any of the preceding claims, wherein the insulating film (11) comprises a number of layers, optionally provided on top of each other and/or distanced from each other along the substrate (2).

7. Resistor structure of claim 6, wherein the film has different thicknesses (t), optionally a first thickness being between 5 and 80 µm, and a second thickness being between 2 and 40 µm and, where the first thickness is larger than the second thickness by at least 50% or at least 5 µm.

8. Resistor structure of any of the preceding claims, wherein the dielectric strength of the insulator film (11) is larger than the dielectric strength of the substrate (2) and/or the porosity of the insulator film (11) is smaller than the porosity of the substrate (2).

9. Resistor structure of any of the preceding claims, wherein the insulating film (11) comprises at least 10%, preferably at least 50% of glass by weight.

10. Resistor structure of any of the preceding claims, wherein the first insulating film part (11-1) at least partially runs perpendicular to the resistive path (3).

11. Resistor structure of any of the preceding claims, wherein the first insulating film part (11-1) at least partially runs parallel to a part of the terminal (4) and/or the resistive path (3).

12. Resistor structure of any of the preceding claims, wherein the first insulating film part (11-1) at least partially extends beyond/projects from a part of the resistive path (3) and/or of the terminal (4), in a direction perpendicular to the thickness direction (D) on the surface of the substrate (2).

13. Resistor structure of any of the preceding claims, wherein the first insulating film part (11-1) is positioned underneath at least a part of a resistive trace (8) of the resistive path (3), at which the resistive trace of the resistive path (3) ends or changes its direction, such as at a turnaround (14).

14. Resistor structure of any of the preceding claims, wherein the first insulating film part (11-1) is below a transition element (7) connected to a resistive trace (8) of the resistive path (3) and/or
below an interconnecting element (12) connecting at least two resistive traces (8) of the resistive path (3) and the portion of the terminal (4-2)
and/or
below an interconnecting path (13) connecting at least an end of a first resistive path (3-1) and an end of a second resistive path (3-2) and the portion of the terminal (4-2), wherein the resistive path (3) comprises at least the first (3-1) and second (3-2) resistive paths.

15. Voltage divider arrangement (5) for electrical power systems for transformation of voltage, the voltage divider arrangement comprising a first resistor structure (1) of any of the preceding claims, and a second resistor structure (1), optionally of any of the preceding claims, wherein the first and second resistor structures are connected in series and the first and second resistor structures differ as to their resistance.

16. Electrical device comprising the resistor structure (1) and/or the voltage divider arrangement (5) of any of the preceding claims.
